# EUROPEAN PATENT APPLICATION

(11) **EP 2 541 631 A2**
(43) Date of publication of application: **02.01.2013**
(21) Application number: 11747748.9
(22) Date of filing: 25.02.2011
(51) Int. Cl.: H01L 33/50

(54) **LIGHT EMITTING DIODE AND METHOD FOR MANUFACTURING SAME**

(30) Priority: 25.02.2010 KR 20100017390
(71) Applicant: Lightizer Korea Co., Ltd, Gangnam-gu, Seoul 135-010 (KR)
(72) Inventor: CHO, Byoung-gu, Seoul 135-110 (KR)
(74) Representative: Sherrard-Smith, Hugh
(86) International application number: PCT/KR2011/001357
(87) International publication number: WO 2011/105858

(57) **Abstract**

The present invention relates to a light emitting diode (LED) that enhances productivity and a method for manufacturing same. The disclosed LED comprises: a light emitting semiconductor chip which is provided with a n-type semiconductor layer, an active layer, and a p-type semiconductor layer; a fluorescent material layer which has a luminescence mixing ratio that is based on the wavelength of the emitted light from the light emitting semiconductor chip so that the light emitted from the light emitting semiconductor chip is converted to a desired intensity, and which is coated on the top surface of the light emitting semiconductor chip; and a connecting layer which is placed between the fluorescent material layer and the light emitting semiconductor chip and connects the fluorescent material layer to the light emitting semiconductor chip.

## Description

### TECHNICAL FIELD

The present disclosure relates to a light emitting diode and a method of manufacturing the same, and more particularly, to a light emitting diode able to improve productivity and a method of manufacturing the same.

### BACKGROUND ART

Light emitting diodes (LEDs) are energy efficient products and the use of the LEDs has been increased, and research and development of the LEDs have been continued. In this aspect, white light emitted from the light emitting diode is required, but realization of white light is not facilitated. Various new methods for realizing white light have been attempted in the past.

However, such various approaches were performed at a chip level instead of a wafer level and these approaches may cause a waste of chips.

Further, none of the existing approaches may change a ratio of a phosphor (fluorescent substance) based on the result of fundamental measurement such as a wavelength of emitted light.

Therefore, there is a need for a light emitting diode according to a new approach and a method of manufacturing the same.

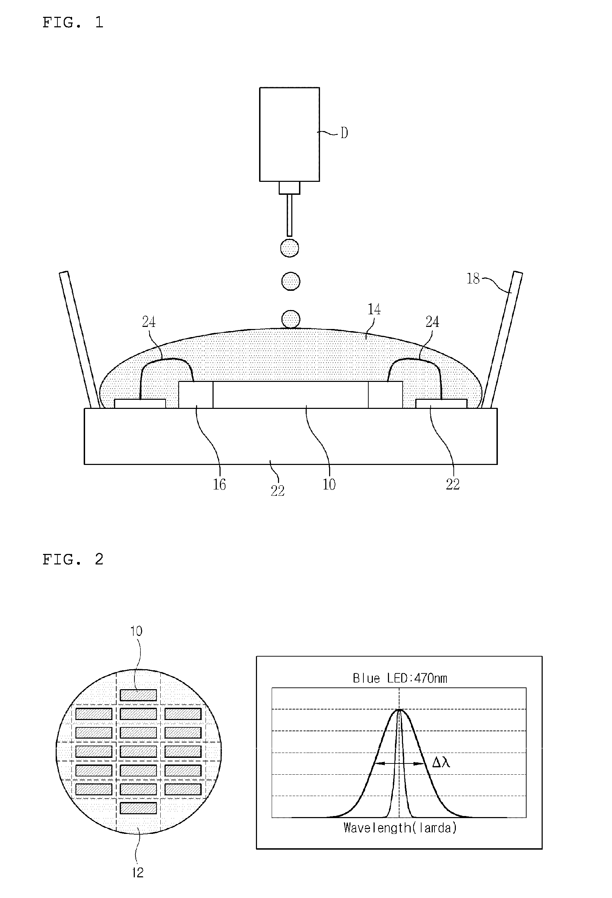

FIG. 1 schematically illustrates a light emitting diode chip 1 manufactured by a typical packaging process at a chip level.

As schematically illustrated in FIG. 1, the individual light emitting diode chip 1 is typically mounted on a lead frame 2 and a packaging process is performed at a chip level. First, the light emitting diode chip 1 is attached to a center portion of the lead frame 2 having a cup-shaped dam 2b, and then an electrode pad 3 on the chip 1 and an electrode 2a formed on the lead frame 2 are bonded each other with a wire 10. Next, in order to allow white light to be emitted, a phosphor/silicon mixed material, in which corresponding phosphor and Si material are mixed, is dispensed on a surface of the light emitting diode chip 1 by using a dispenser D, in consideration of a target white color coordinate.

The above-described phosphor coating technique at a chip level may have the following limitations.

First, since the phosphor/silicon mixed material (fluorescence substance) is dispensed at a chip level, a process may be complicated and thus, productivity may decrease.

Second, since the phosphor/silicon mixed material (layer) alone is adhered to the light emitting diode chip 1, adhesive strength with respect to the light emitting diode chip 1 may decrease when a mixing ratio of the phosphor in the phosphor/silicon mixed material increases, and thus, the phosphor/silicon mixed layer may be delaminated during a subsequent process. The delamination may become more severe when the phosphor/silicon mixed layer is dispensed during a wafer-level process in addition to a chip-level process.

Third, since a thickness of the phosphor/silicon mixed layer (a minimum of 300 µm or more) is high, an optical mean free path may vary according to a surface position of the light emitting diode chip 1 to thus generate a color deviation (a LED binning phenomenon). The generation of the color deviation may cause many limitations during optical design. Therefore, a conformal coating, in which the thickness of the phosphor/silicon mixed layer is uniform, is required.

U.S. Patent Nos. 6,576,488 and 6,686,581 disclosed that phosphor structures are formed on surfaces of the LED chips by electrophoresis. Phosphor powders were changed into gels by charges and thereafter, the phosphor structures were formed by an electric field caused by an applied voltage. The electric field must be applied to the surface of the LED chip in order for a conductive plate to attract the phosphors to be attached thereto.

U.S. Patent No. 6,650,044 disclosed that a phosphor structure was formed on a surface of a LED chip by using a screen printing method. In the screen printing method, a stencil is first prepared and a solidification agent must be added to phosphor powders in order to solidify the phosphor powders.

Korean Patent No. 10-0869694 is characterized by that an upper portion of a semiconductor light emitting device (a light emitting diode chip) is coated with a phosphor powder layer and then protective layers 1 and 2 are introduced to protect the phosphor powder layer. However, since the upper surface of the semiconductor light emitting device is directly coated with the phosphor powder layer, the phosphor powder layer may be delaminated.

### DISCLOSURE OF THE INVENTION

### TECHNICAL PROBLEM

Embodiments provide a light emitting diode able to improve productivity and a method of manufacturing the same.

Embodiments also provide a light emitting diode able to prevent generation of delamination of a phosphor/silicon mixed material and a method of manufacturing the same.

Embodiments also provide a light emitting diode able to make a thickness of a phosphor/silicon mixed layer relatively uniform and a method of manufacturing the same.

### TECHNICAL SOLUTION

In one embodiment, a light emitting diode includes: a light emitting semiconductor chip composed of an N-type semiconductor layer, an active layer, and a P-type semiconductor layer; a fluorescent material layer having a phosphor mixing ratio based on a wavelength of light emitted from the light emitting semiconductor chip to convert the light emitted from the light emitting semiconductor chip to a desired light and coated on the light emitting diode chip; and a bonding layer disposed between the fluorescent material layer and the light emitting semiconductor chip to bond the fluorescent material layer to the light emitting semiconductor chip.

Also, the bonding layer may include at least any one of a silicon resin, an epoxy resin, an organic polymer, and a glass resin.

Herein, the light emitting diode may further include a protective layer coated on the fluorescent material layer to protect the fluorescent material layer.

Further, the protective layer may include at least any one of a silicon resin, an epoxy resin, an organic polymer, and a glass resin.

A wavelength of the light emitted from the light emitting semiconductor chip may be a blue wavelength or ultraviolet wavelength.

In another embodiment, a method of manufacturing a light emitting diode includes: depositing an N-type semiconductor layer, an active layer, and a P-type semiconductor layer on a wafer substrate to form a light emitting semiconductor chip; detecting a wavelength of light emitted from the light emitting semiconductor chip; using wavelength data of the detected light emitting semiconductor chip to determine a phosphor mixing ratio corresponding thereto to allow the light emitting semiconductor chip to emit a desired light; forming a bonding layer on the light emitting semiconductor chip before coating the light emitting semiconductor chip with a fluorescent substance according to the determined phosphor mixing ratio; and forming a fluorescent material layer on the bonding layer according to the determined mixing ratio.

Herein, the method may further include masking a region of the light emitting semiconductor chip before the forming of the bonding layer.

Also, the method may further include forming a protective layer on the fluorescent material layer.

In further another embodiment, a method of manufacturing a light emitting diode includes: depositing an N-type semiconductor layer, an active layer, and a P-type semiconductor layer on a wafer substrate to form a light emitting semiconductor chip; detecting a wavelength of light emitted from the light emitting semiconductor chip; using wavelength data of the detected light emitting semiconductor chip to determine a phosphor mixing ratio corresponding thereto to allow the light emitting semiconductor chip to emit a desired light; forming a fluorescent material layer according to the determined mixing ratio; and forming a protective layer on the fluorescent material layer.

Herein, the method may further include masking a region of the light emitting semiconductor chip before the forming of the fluorescent material layer.

### ADVANTAGEOUS EFFECTS

According to a light emitting diode of the foregoing present invention and a method of manufacturing the same, the following effects may be obtained.

First, since a phosphor+Si material for converting to the same target white color in a color coordinate system is determined for each unit chip at a wafer level to coat on each chip, a color deviation of white light emitted for each chip may decrease. Thus, a white light diode processing yield may increase.

Second, a design margin may increase during design of an optical lens using each white light emitting diode chip due to the minimization of a color deviation.

Third, since a phosphor coating process is performed on each chip at a wafer level, a sorting process, in which LEDs having wavelengths within a similar range are sorted for each chip, is not required. Also, since a white color coordinate is already obtained at a wafer level instead of a packaging level, a separate packaging process may not be required and additional material costs may not be generated.

Fourth, since a white light chip is manufactured at a wafer level, production equipment investment may decrease and costs for managing white light diode chips may be reduced. In particular, equipments for performing a packaging process, such as a sorting equipment for sorting, may not be required.

Fifth, since a white light diode chip is completed for each chip at a wafer level, typical processes, such as separate die attach, wiring, and phosphor coating, may be omitted when chip on module (COM) and chip on board (COB) using a flip chip method are used. Therefore, processing costs and material costs may be reduced.

Sixth, since the distance between the light emitting diode chips constituting a module is minimized, a light source of a high density integrated point source concept may be configured. Therefore, optical design may be facilitated or a high brightness lighting configuration may be possible through an increase in the number of the light emitting diode chips in the module.

Seventh, when a chip size is increased in order to increase brightness in a single light emitting diode chip, wavelength distribution in the single chip may be generated. However, since wavelength compensation for a unit chip may be possible in the present invention, uniform color may be realized.

Eighth, since the number of electrode pads used for wiring may decrease, sizes of electrode pads not actually used for wiring may be significantly decreased. As a result, processing may be simple and productivity may be improved. Also, an additional effect, in which the brightness increases as much as a decrease in the area of the corresponding electrode pad, may be expected.

Ninth, since the number of the electrode pads used for wiring decreases, packaging process costs may be reduced and an effect of increasing mass productivity may be expected.

Tenth, when a single module is formed of red, green, blue colors at a wafer level, combination of various colors may be possible in the single module. This may be used for outdoor and indoor display boards and high-quality design lighting, and may be used for realizing various colors because the single module is designed to allow red, green and blue (RGB) colors to be in the nearest distance. In particular, generation of various colors using RGB in a minimum pixel unit may be possible in high-quality lighting for interiors requiring various colors and indoor and outdoor display boards.

Eleventh, conformal coating of a phosphor/silicon mixed layer, which is applicable to both chip-level and wafer-level phosphor formation processes and minimizes binning phenomenon requiring in the phosphor formation process, may be possible. Also, a phosphor/silicon mixing ratio able to compensate the wavelength distribution of the chip may be easily controlled.

Twelfth, it may contribute to an increase in adhesion by performing an adhesive function on light emitting semiconductor device substrate and phosphor/silicon mixed layer.

Thirteenth, surface damage/scratch, which may occur in the phosphor/silicon mixed layer during a subsequent packaging process, may be prevented by introduction of a phosphor protective layer.

### BRIEF DESCRIPTION OF THE DRAWINGS

Fig. 1 is a schematic view illustrating a light emitting diode coated with a phosphor/silicon mixed layer at a typical packaging level.
Fig. 2 is a chip wavelength distribution graph in a light emitting diode wafer.
Fig. 3 is a color coordinate system and a table illustrating chip wavelengths measured with respect to chip types 1, 2, and 3 for realizing white light having the same color coordinate and corresponding phosphor+Si mixed ratios.
Fig. 4 is a schematic view illustrating a conformal coating mode performed on each chip at a wafer level in a method of manufacturing a light emitting diode of the present invention.
Fig. 5 is a schematic view illustrating conformal coating in a method of manufacturing a light emitting diode according to a first embodiment of the present invention.
Fig. 6 is a schematic view illustrating conformal coating in a method of manufacturing a light emitting diode according to a second embodiment of the present invention.
Fig. 7 is a schematic view illustrating conformal coating in a method of manufacturing a light emitting diode according to a third embodiment of the present invention.
Fig. 8 is a flowchart schematically illustrating a method of manufacturing a light emitting diode according to a fourth embodiment of the present invention.
Fig. 9 is a schematic plan view illustrating a wafer 100 in which a semiconductor module 100 is formed according to a fifth embodiment of the present invention.
Fig.10 is a schematic view illustrating a conformal coating mode performed on each chip in order to form a fluorescent layer 127 of the semiconductor module 100 according to the fifth embodiment of the present invention.
Fig. 11 is a schematic plan view illustrating a wafer 100 in which a semiconductor module 200 is formed according to a sixth embodiment of the present invention.
Fig. 12 is a schematic plan view illustrating a semiconductor module 300 according to a seventh embodiment of the present invention.
Fig. 13 is a schematic plan view illustrating a semiconductor module 400 according to an eighth embodiment of the present invention.
Fig. 14 is a schematic plan view illustrating a semiconductor module 500 according to a ninth embodiment of the present invention.
Fig. 15 is a schematic view illustrating a structure of a light emitting diode according to a tenth embodiment of the present invention.
Fig. 16 is a schematic view illustrating a structure of a light emitting diode according to an eleventh embodiment of the present invention.
Fig. 17 is a diagram for describing a method of manufacturing a light emitting diode according to a twelfth embodiment of the present invention.
Fig. 18 is a diagram for describing a method of manufacturing a light emitting diode according to a thirteenth embodiment of the present invention.

### MODE FOR CARRYING OUT THE INVENTION

As described above, the present invention relates to a light emitting diode able to emit light having a desired wavelength by being coated with a phosphor/silicon mixed layer and a method of manufacturing the light emitting diode. More particularly, a wavelength of light emitted from a light emitting diode (LED) (e.g., blue LED or ultra-violet LED) is, for example, measured at a wafer level. Conformal coating is performed on the LED based on the result of wavelength measurement. The conformal coating has a phosphor mixing ratio based on the wavelength. Also, the phosphor mixing ratio includes at least one color of yellow, green, or red. Accordingly, light emitted from the LED is converted to white light by using conformal coating. In embodiments, the foregoing operations are performed at a wafer level and thus, better uniformity and consistency may be obtained.

Meanwhile, a wavelength distribution may exist between each chip in a LED wafer due to process deviation and equipment deviation in a metal organic chemical vapor deposition (MOCVD) process among epitaxial (EPI) processes of the LED chip. Fig. 2 is the result of measuring wavelengths of blue light for chips 10 in an arbitrary LED wafer 12. The chips 10 in the wafer 12 do not have the same single wavelength but have the wavelength distribution between the chips 10. In general, when a wavelength difference between the chips 10 is generated in an amount of 5 nm or more, the difference may be visually recognized.

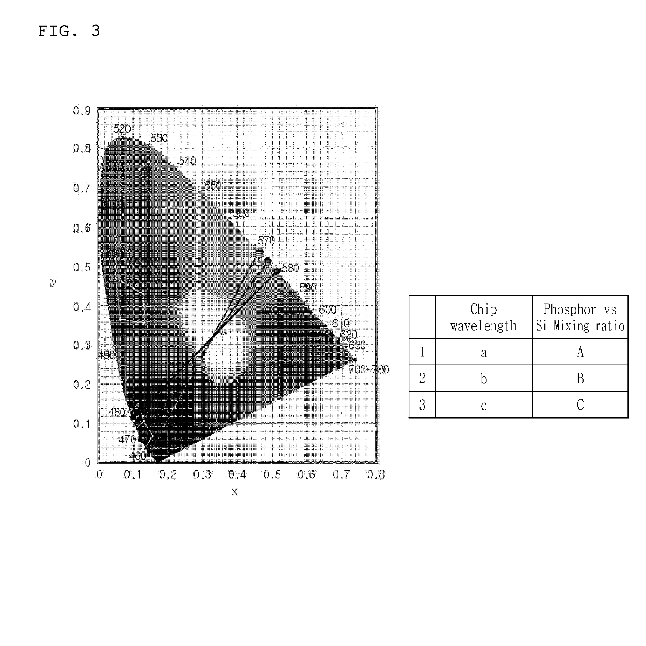

Fig. 3 shows a RGB color coordinate system. When the same phosphor is overall applied at a wafer level in order to convert the chips 10 on the same wafer 12 to white light in a state of having the wavelength distribution between the chips 10 in the same wafer 12 as in Fig. 2, a white color coordinate may change for the each chip. Therefore, white light having the same white color coordinate may be obtained by only using different phosphor mixing ratios according to the wavelength of each individual chip 10.

Blue portion number 1 in a color coordinate system of Fig. 3 denotes a case in which the wavelength of the chip is a, and in this case, a mixing ratio of yellow, red, and green (Y, R, G) phosphors of A must be used to form a target white color coordinate. Also, when the wavelengths of the chips are respectively b and c as in numbers 2 and 3, the mixing ratios of phosphors of B and C different from A must be respectively used to form the same target white color coordinate as in number 1. Herein, the phosphors having the foregoing mixing ratios may be mixed together with silicon (Si).

When a fluorescent layer having the same mixing ratio A of phosphor and silicon is used for the chips having different wavelengths of a, b, and c, three chips may have different target white color coordinates. When the white color coordinate changes, color distribution occurs, and thus, product configuration may be difficult when the LEDs are used in a back light unit (BLU) used in a liquid crystal display (LCD) device and lighting. According to the foregoing limitation, a process of coating the phosphor is performed at an individual chip level during a LED package (PKG) process instead of a wafer level and a process of sorting (ranking) the individual chips by the wavelength of blue light emitted from each chip is performed before the process of coating the phosphor.

However, when the phosphor coating is performed on each individual chip during a packaging process, this may be a major factor of increasing product costs, because the sorted individual chips must be stored and maintained in addition to the foregoing sorting process and a process sequence increases and becomes complicated.

Fig. 1 schematically illustrates a process of coating a phosphor at each individual chip level. First, in a lead frame 16 having a cup 18, a LED chip 10 is attached to the center of the cup 18, and a metal pad 20 of the LED chip 10 and an electrode line 22 of the lead frame 16 are bonded to each other by a wire 24. In order to form a target white color coordinate, a coating layer 14 (a phosphor+Si material) designed according to the wavelength of a corresponding chip is dispensed on a surface of the LED chip 10.

The above-described phosphor coating technique at a chip level has a few limitations.

First, since a thickness of the phosphor+Si material (a minimum of 300 µm or more) is high, an optical mean free path changes according to a surface position of the LED chip and thus, a color deviation may occur (LED binning). The occurrence of the color deviation results in a lot of limitations during an optical design.

Second, since the process of coating a phosphor is not performed at a wafer level but performed at a chip level, separate package material and processing costs may additionally occur in addition to the cost of the chip, when defects are generated due to a deviation of white color coordinate after packaging.

Third, a sorting process for the same wavelength range with respect to the wavelength distribution of the chips in a wafer is accompanied in advance in order to perform chip-level coating, and in this case, processing time may be extended and equipment investment costs may occur. When the phosphor coating process is performed on each unit chip at a wafer level, the separate sorting process is not required and the white color coordinate may be obtained in advance at a wafer level instead of a package level. Therefore, separate package processing and material costs may not additionally occur during the generation of defect chips.

As described above, the method of manufacturing a white light emitting diode according to the present invention allows a manufacturing process of a white light emitting diode to be performed at a wafer level different from a chip level packaging method. In particular, wavelength data for the each unit chip are measured in advance at a wafer level, the foregoing relatively lower level, to accurately determine a mixing ratio of phosphors (yellow: Y, green: G, and red: R) appropriate for the measured wavelength in order to convert the corresponding wavelength of the each unit chip into the same target white light. Then, a conformal coating layer is formed for the each unit chip in such a manner that a phosphor having the determined mixing ratio is dispensed on the each unit chip at a wafer level. Therefore, a thickness of the fluorescent material conformal coating layer may be relatively lower in comparison to that obtained when the coating is performed at a chip level.

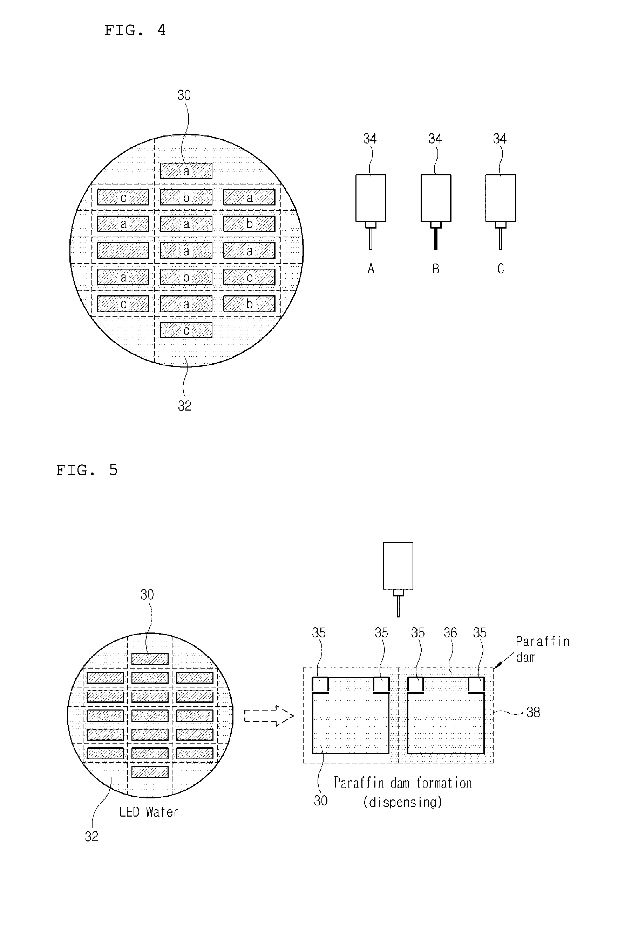

Fig. 4 schematically illustrates a fluorescent material coating process in the method of manufacturing a light emitting diode, which is commonly applied to the present invention. In order to realize the same white color coordinate with respect to entire chips 30 in a wafer 32, an appropriate phosphor mixing ratio to be used on the each unit chip 30 is determined based on the result of measuring wavelengths of the entire chips 30. For example, when the wave lengths are a, b, and c, mixing ratios may be A, B, and C, respectively. Three identical dispensers 34A, 34B, and 34C are prepared for the foregoing three types or more of mixing ratios and each dispenser includes a phosphor having a different mixing ratio. As shown in Fig. 4, the plurality of dispensers 34A to 34C dispense a corresponding phosphor+Si material (hereinafter, referred to as "fluorescent substance") on the each unit chip at a wafer level to form a conformal phosphor coating layer on the chip. As a result, a white LED emitting white light may be obtained through the phosphor coating at a wafer level.

Herein, the LED chips 30 on the wafer 32 before being coated with the fluorescent substance may be denoted as a light emitting part. The light emitting part is composed of an N layer, a P layer, and an active layer, and the foregoing configuration is already known so that detailed description will not be provided.

Herein, the meaning of "a wafer level" denotes a stage of the wafer before the each unit LED chip 30 formed on the wafer is diced and separated.

As the number of the dispensers increases, coating of a fluorescent substance having a more accurate mixing ratio on the individual unit chip having various wavelength distributions formed at a wafer level may be possible.

In some cases, each unit chip at a wafer level may be coated with a fluorescent substance having an arbitrary mixing ratio by using the foregoing plurality of dispensers 34A to 34C. More particularly, a single unit chip may be multiply coated with fluorescent substances having different mixing ratios by using at least two or more dispensers among the plurality of dispensers 34A to 34C and thus, the desired fluorescent substance having an arbitrary mixing ratio may be coated. That is, the multiply coated fluorescent substances may finally become a desired fluorescent layer having an arbitrary mixing ratio.

Hereinafter, three embodiments are suggested in the present invention, in which a phosphor+Si material (fluorescent substance) is independently coated for the each unit chip 30 at a wafer level.

The first embodiment is illustrated in Fig. 5.

In this case, a material containing paraffin 36 (other materials may be contained) is printed on a scribe line between a chip 30 and a chip 30 in a wafer 32. Thus, coating of the fluorescent substance on the scribe line may be prevented. Next, the material containing paraffin 36 is also printed on a metal pad 35 portion along a pad line to prevent the fluorescent substance of phosphor+Si to be dispensed by a dispenser from penetrating the metal pad 35 portion. In this case, when the material such as paraffin is printed, a thickness of the fluorescent material coating layer is about 100 µm. A major function of the paraffin material is to act as a guide dam 38 which prevents flow of the fluorescent substance to coat on the chip 30 and contains the fluorescent substance inside the guide dam 38.

A method of manufacturing a light emitting diode according to the present invention is described below.
(1) A wavelength of each diode chip 30 is measured at a wafer level;
(2) A mixing ratio of phosphor (Y, G, and B) and Si corresponding to a target white color coordinate for a group of the measured wavelengths is determined;
(3) As illustrated in Fig. 5, a guide dam 38 is formed by printing a material such as paraffin 36 on scribe lines and metal pad 35 portions in the each chip 30 in a wafer 32;
(4) In order to realize a target white color coordinate, a fluorescent substance, which is formed of phosphor having a corresponding mixing ratio with respect to the wavelength of the each chip 30 in the wafer 32 and a silicon material for bonding the phosphor onto the chip 30, is coated;

Herein, the fluorescent substance containing the phosphor having a predetermined mixing ratio and the silicon material may be dispensed through the foregoing plurality of dispensers (34A to 34C in Fig. 4).
(5) The phosphor+Si material is hard cured in an oven;
(6) Next, the chip 30 coated with the fluorescent substance on the wafer 32 is diced along the scribe lines.

Herein, it was described in Fig. 5 that the scribe line may be formed for the individual chip 30. However, when the fluorescent material coating may be simultaneously performed on two chips 30 by one dispenser as in the case that the fluorescent substance coating is possible by the same dispenser because a wavelength distribution is within an error range, a scribe line may also be formed in a shape surrounding the two chips 30 as needed.

If necessary, when the fluorescent material coating is possible by one dispenser because three or more adjacent chips 30 have a wavelength distribution within an error range, a scribe line may be formed to surround the three or more adjacent chips 30.

Also, between the foregoing operations (3) and (4), an operation of distinguishing which dispenser must be used to coat the fluorescent substance on the individual chip 30 from the measured wavelength data of the individual chips 30 on the wafer 32 may be further included. That is, since the wavelength distribution between the individual chips 30 may variously occur, a range of the wavelength distribution compensable by each dispenser may be determined in order to dispense the fluorescent substances by limited dispensers.

Herein, when a predetermined phosphor mixing ratio is already determined for each of the plurality of dispensers, the foregoing operation (2) may be replaced by an operation of distinguishing which dispenser among the plurality of dispensers is suitable for the individual chip 30 from the measured wavelength data of the individual chips 30 on the wafer 32 through operation (1).

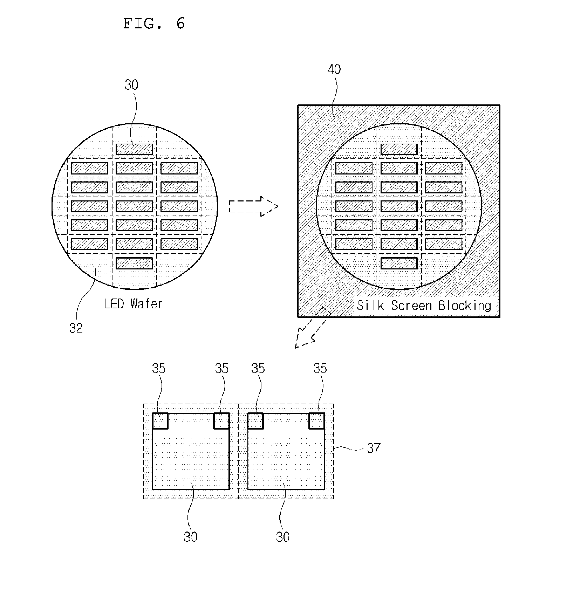

The second embodiment of the present invention is described with reference to Fig. 6 below.

In this case, a scribe line between a chip 30 and a chip 30 and metal pad portions 35 may be blocked by a silk screen 40 or a metal mask 40 to prevent a fluorescent substance of phosphor+Si to be dispensed from penetrating. The blocking is performed and the phosphor+Si material is then dispensed by using a dispensing method according to the wavelength of each unit chip at a wafer level. The method of manufacturing a light emitting diode according to the present invention is described in more detail below.
(1) A wavelength of each configured diode chip is measured at a wafer level;
(2) A mixing ratio of phosphor (Y, G, and B) and Si corresponding to a target white color coordinate for a group of the measured wavelengths is determined;
(3) As illustrated in Fig. 6, scribe lines and metal pad 35 portions in the each chip in a wafer are blocked by using a silk screen 40;
(4) In order to realize a target white color coordinate, a fluorescent substance, which is formed of a phosphor having a corresponding mixing ratio with respect to the wavelength of the each chip and a silicon material, is coated on the each chip;
(5) The phosphor+Si material is temporarily cured;
(6) The silk screen and/or metal mask block are removed;
(7) The fluorescent substance of phosphor+Si is hard cured in an oven.

Herein, in some cases, the foregoing temporary curing operation (5) may be omitted.

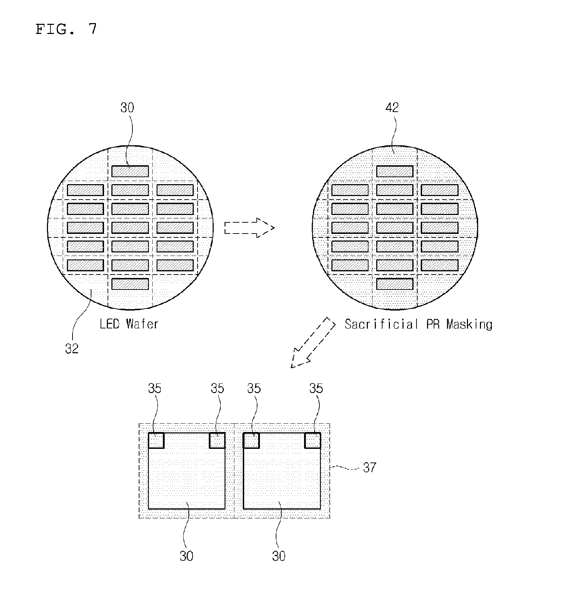

The third embodiment of the present invention is described with reference to Fig. 7 below.

In this case, a scribe line 37 between a chip 30 and a chip 30 and metal pad 35 portions may be masked by a sacrificial layer 42 of a photoresist (PR) and/or an organic material to prevent a dispensed fluorescent substance of phosphor+Si from penetrating. The masking is performed and the fluorescent substance of phosphor+Si is then dispensed by using a dispensing method according to the wavelength of each unit chip at a wafer level. The method of manufacturing a light emitting diode according to the present embodiment is described in more detail below.
(1) A wavelength of each configured diode chip is measured at a wafer level;
(2) A mixing ratio of phosphor (Y, G, and B) and Si corresponding to a target white color coordinate for a group of the measured wavelengths is determined;
(3) As illustrated in Fig. 7, scribe lines and metal pad portions in the each chip in a wafer are masked by using the sacrificial layer or the like;
(4) In order to realize a target white color coordinate, a fluorescent substance of phosphor and silicon having a corresponding mixing ratio with respect to the wavelength of the each chip is coated;
(5) The fluorescent substance of phosphor+Si is hard cured in an oven;
(6) The sacrificial layer PR on the scribe lines and the metal pad portions is removed.

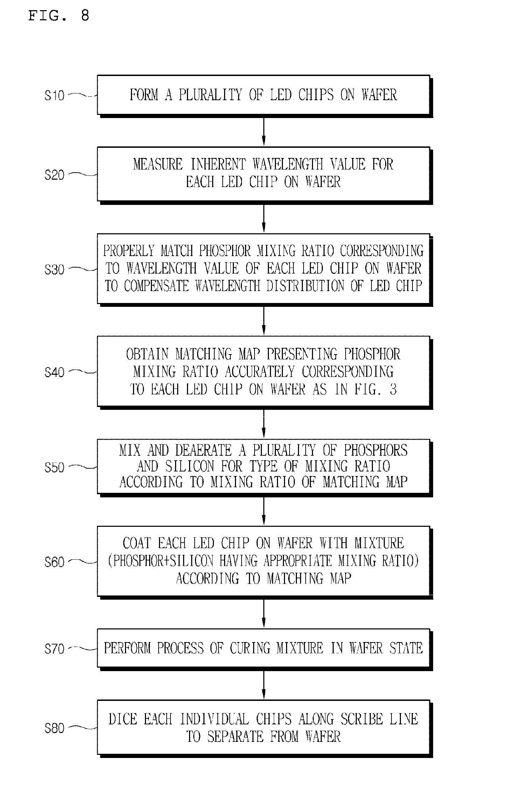

Hereinafter, a method of manufacturing a light emitting diode according to the fourth embodiment of the present invention is described in more detail with reference to Fig. 8 below.

First, a plurality of LED chips is formed on a wafer (S10). Herein, the LED may be a blue LED or ultra-violet (UV) LED emitting blue light or ultraviolet ray, respectively.

Next, an inherent wavelength value emitted from each LED chip on the wafer is measured (S20).

In order to compensate a wavelength distribution of the LED chip, a phosphor mixing ratio corresponding to the wavelength value of the each LED chip on the wafer is determined (S30). Herein, since the each LED formed by a semiconductor process in operation S10 does not output the same wavelength but has a wavelength distribution with an error, phosphor mixing ratios corresponding to the measured wavelengths of the individual chips are determined for photo converting the each individual chips to emit white light in the same color coordinate.

Next, as illustrated in Fig. 4, a matching map presenting a phosphor mixing ratio accurately corresponding to the measured wavelength value of each LED chip on the wafer is obtained (S40).

A plurality of phosphors and silicon are mixed for a type of mixing ratios according to the mixing ratios of the matching map and deaerated (S50).

Each LED chip on the wafer is coated with the fluorescent substance (phosphor+Si having an appropriate mixing ratio) mixed according to the matching map (S60).

The fluorescent substance is cured in a wafer state (S70).

The individual LED chip is diced along scribe lines on the wafer and is separated from the wafer (S80).

Herein, coating of the fluorescent substance after masking the scribe lines and the metal pads of the LED chip was described in the first to third embodiments and thus, the description thereof will be omitted.

The method of manufacturing a single LED chip by coating the phosphor/silicon mixing layer at a wafer level was described above. Hereinafter, a method of manufacturing a light emitting diode module, in which single LED chips are electrically connected to one another at a wafer level, will be described.

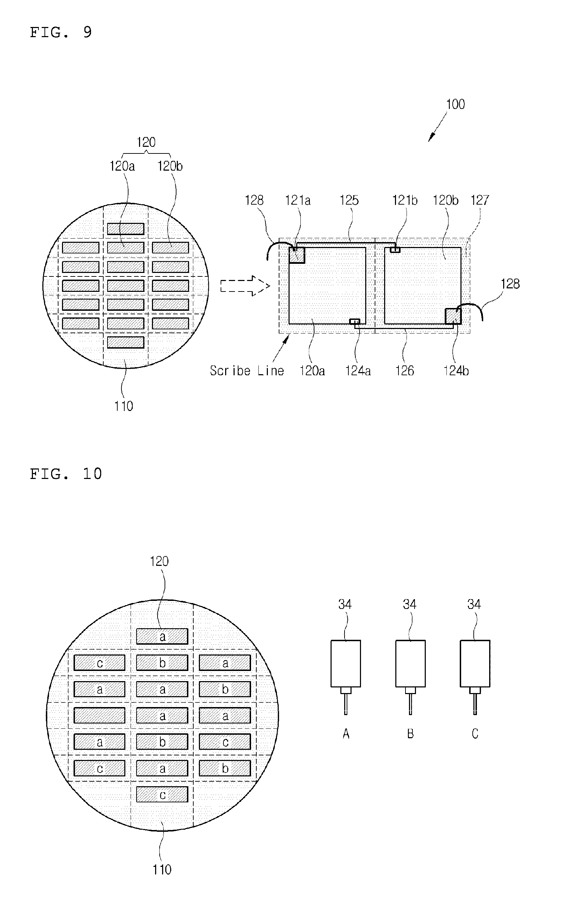

As shown in Fig. 9, a light emitting diode module 100 according to the fifth embodiment of the present invention is formed by electrically connecting two or more light emitting diode chips 120, 120a, and 120b formed on a wafer 110. That is, the light emitting diode module 100 denotes a plurality of light emitting diode chips 120, 120a, and 120b electrically connected to one another on the wafer 110.

The plurality of light emitting diode chips 120, 120a, and 120b may be connected to one another in series or parallel.

Herein, each of the plurality of light emitting diode chips 120, 120a, and 120b includes an N-type semiconductor layer (not shown), an active layer (not shown), and a P-type semiconductor layer (not shown) deposited on the wafer 110.

In Fig. 9, a right diagram is a plan view illustrating an enlarged important portion of the left wafer 110 in which at least one light emitting diode module 100 is formed. For example, illustrates the light emitting diode module 100 formed of two light emitting diode chips, i.e., a first light emitting diode chip 120a and a second light emitting diode chip 120b electrically connected to each other by metal lines 125 and 126. Of course, the light emitting diode module 100 may be formed of three or more light emitting diode chips.

The first and second light emitting diode chips 120a and 120b include N-type electrode pads 124a and 124b and P-type electrode pads 121a and 121b for applying a bias voltage to the N-type semiconductor layer (not shown) and the P-type semiconductor layer (not shown), respectively.

The P-type electrode pad 121a of the first light emitting diode chip 120a and the P-type electrode pad 121b of the second light emitting diode chip 120b are electrically connected to each other by the metal line 125 formed on a surface of the wafer 110 through a semiconductor process. Also, the N-type electrode pad 124a of the first light emitting diode chip 120a and the N-type electrode pad 124b of the second light emitting diode chip 120b are electrically connected to each other by the other metal line 126.

The metal lines 125 and 126 may be simultaneously formed when the P-type and N-type electrode pads 121a, 121b, 124a, and 124b are formed or may be formed through separate metal thin film deposition and photo/etching process. The metal lines 125 and 126 may be disposed near the scribe lines so as not to obstruct light emission of the light emitting diodes due to the metal lines 125 and 126. Dicing is later performed on each module along the scribe lines. Herein, the scribe lines may be arranged to surround the light emitting diode module 100.

Before the metal lines 125 and 126 are formed, wavelengths of all individual light emitting diode chips 120 including the first and second light emitting diode chips 120a and 120b on the wafer 110 may also be detected. The wavelength of output light of the individual light emitting diode chip 120 may be detected by applying a bias voltage to the N-type and P-type electrode pads formed on the each light emitting diode chip 120.

Of course, if necessary, the metal lines 125 and 126 are formed and then the wavelength of the output light emitted from the module 100 may also be detected for a plurality of light emitting diode modules 100 formed on the wafer 110. More particularly, a bias voltage is applied to the P-type electrode pad 121a and the N-type electrode pad 124b in order to detect the wavelengths of output lights emitted from the first and second light emitting diode chips 120a and 120b having the metal lines 125 and 126 formed thereon.

The light emitting diode module 100 further includes a fluorescent layer 127 in which a fluorescent substance is coated according to a phosphor mixing ratio for converting to a desired light by compensating the wavelength of the output light. Herein, when coating the fluorescent layer 127, masking may be performed such that at least one P-type electrode pad and N-type electrode pad are not coated with the fluorescent layer 127 in order for the module 100 to be electrically connected to an external lead frame (not shown). Also, a guide dam (not shown) may be formed of a material such as paraffin at a boundary region of the light emitting diode module 100 in order for the fluorescent layer 127 not to flow and exist inside the guide dam. The fluorescent substance is dispensed in the guide dam (not shown) by using a dispenser to be described later.

In some cases, before the forming of the fluorescent layer 127, wires 128 may be formed on any one of the P-type electrode pads 121a and 121b and any one of the N-type electrode pads 124a and 124b of the light emitting diode module 100. The fluorescent layer 127 may be formed on the light emitting diode module 100 having the wires 128 formed thereon without the foregoing separate masking. The light emitting diode module 100 may be electrically connected to an external lead frame through the wires 128.

As illustrated in Fig. 3, a wavelength distribution exists between the light emitting diode chips 120 on the wafer 110. For example, a blue LED emitting blue light has a wavelength range of about 440 nm to 470 nm, and in general, it is possible to visually recognize when the difference in the wavelengths between the chips 120 is generated in an amount of 5 nm or more. Therefore, there is a need for applying fluorescent layers having different phosphor mixing ratios in order to output a desired light by using light emitting diode chips 120 having different wavelength distributions.

More particularly, blue portion number 1 in the color coordinate system of Fig. 3 denotes a case in which the wavelength of the chip is a, and in this case, a mixing ratio of yellow, red, and green (Y, R, G) phosphors of A must be used to form a target white color coordinate. Also, when the wavelengths of the chips are respectively b and c as in numbers 2 and 3, the mixing ratios of phosphors of B and C different from A must be respectively used to form the same target white color coordinate as in number 1. Herein, the phosphors having the foregoing mixing ratios may be mixed together with silicon.

When a fluorescent layer having the same mixing ratio A of phosphor and silicon is used for the chips having different wavelengths of a, b, and c, three chips may have different target white color coordinates. When the white color coordinate changes, product configuration may be difficult due to the generation of color distribution when the LEDs are used in a back light unit (BLU) used in a liquid crystal display (LCD) device and lighting.

Fig.10 schematically illustrates a fluorescent material coating process for a light emitting diode chip 120 on a wafer 110, which is commonly applied to the present invention.

As shown in the left side of Fig. 10, output lights of the entire light emitting diode chips 120 on the wafer 120 may be detected to have a distribution of three types of "a", "b", and "c".

In order for the each chip 120 to emit a desired output light with respect to the entire chips 120 in the wafer 110, an appropriate phosphor mixing ratio to be coated on the each unit chip 120 is determined based on the result of measuring the wavelengths of the entire chips 120. When the desired output light is white light, i.e., with respect to a target white color coordinate, as described in Fig. 3, mixing ratios may be A, B, and C when the detected wave lengths of the chips 120 are "a", "b", and "c", respectively. Three identical dispensers 34A, 34B, and 34C are prepared for the foregoing three types or more of mixing ratios and each dispenser includes a phosphor having a different mixing ratio. As shown in Fig. 10, the plurality of dispensers 34A to 34C dispense corresponding phosphor+Si materials (hereinafter, referred to as "fluorescent substance") at a wafer level to form conformal phosphor coating layers on the chips. Thus, the foregoing coating layer 127 may be formed on the chip. As a result, the light emitting diode module 100 emitting a desired light through the phosphor coating at a wafer level may be formed.

Herein, wavelength of the output light emitted from the light emitting diode module 100 composed of the plurality of light emitting diode chips 120a and 120b is calculated by adding those of the output lights of the individual unit chips 120a and 120b, and when the wavelength is detected for the each module 100 during the detection of the wavelength, wavelength compensation may also be performed for the each module 100. For example, the light emitting diode module 100 composed of the two diode chips 120a and 120b may be coated with fluorescent substances having the same mixing ratio. For example, when the wavelength of the output light of the light emitting diode module 100 is "a" as shown in Fig. 4 and white light is a desired light to be finally converted to, a fluorescent layer 127 may be formed on the light emitting diode module 100 through conformal coating by a corresponding dispenser 34A.

As described above, the coated fluorescent layer 127 is cured by oven curing the wafer 110 and then at least one light emitting diode module 100 formed on the wafer 110 may be finally formed by dicing along the foregoing scribe lines.

It was illustrated in the above that the first and second light emitting diode chips 120a and 120b are connected in parallel, but, in some cases, may be connected in series.

The method of manufacturing the light emitting diode module 100 described above will be described with reference to Fig. 9 below.

First, an N-type semiconductor layer, an active layer, and a P-type semiconductor layer are formed on a wafer 110 by deposition (S110).

Next, N-type electrode pads connected to the N-type semiconducting layer and P-type electrode pads connected to the P-type semiconductor layer are formed on the wafer 100 (S120).

Bias voltages are applied to the N-type electrode pads 124a and 124b and the P-type electrode pads 121a and 121b to detect wavelength of output light for each light emitting diode chip 120 on the wafer 100 (S130). Herein, the N-type electrode pad and the P-type electrode pad forming operation S120 may be performed at an arbitrary stage in a process after the wavelength detecting operation S130 and before a coating layer forming operation S160 to be described.

Phosphor mixing ratios for converting the output lights of the plurality of light emitting diode chips 120 to desired lights are determined based on the detected wavelengths (S140).

Metal lines 125 and 126 electrically connecting at least two or more of the plurality of light emitting diode chips 120 are formed on the wafer 110 to form a light emitting diode module 100 (S150).

Herein, the metal line forming operation S150 may precede the wavelength detecting operation S130 and the electrode pad forming operation S120. In this case, the detection of the wavelength of the output light may be performed for the each light emitting module 100 instead of the each light emitting diode chip 120. Coating of a phosphor coating layer 127 to be described later may also be performed for the each light emitting module 100 instead of the each light emitting diode chip 120. That is, as shown in Fig. 3, when the output light wavelength of the light emitting diode module 100 composed of the foregoing two light emitting diode chips 120a and 120b is detected as "a", wave length compensation may be performed by coating the light emitting module 100 with a fluorescent substance having a corresponding phosphor mixing ratio of "A" by using a dispenser 34A.

Each of the plurality of light emitting diode chips 120 is coated with a fluorescent substance according to the phosphor mixing ratio determined in the operation S140 to form the phosphor coating layer 127 (S160). Herein, before the forming of the phosphor coating layer 127, a guide dam (not shown), which becomes a boundary of the coating layer 127, may be formed of paraffin for the each light emitting diode chip 120 on the wafer 110.

The wafer 110, in which the phosphor coating layer 127 is formed on the each light emitting diode chip 120, is oven cured (S170). As a result, the phosphor coating layer 127 is cured.

Finally, the light emitting diode module 100 in the wafer 110 is diced (S180). Herein, the dicing may also be performed by laser cutting or the like.

The light emitting diode module 100 composed of two light emitting diode chips 120a and 120b were described in the foregoing fifth embodiment. However, this is merely an example, and a module composed of three or more light emitting diode chips may be configured.

Also, only a single type module may be formed on the wafer 110, but, in some cases, various types of modules may be formed. Herein, the type of module may be changed according to the arrangement of the constituting light emitting diode chips as well as the number of the light emitting diode chips. For example, a module having four light emitting diode chips connected in serial, i.e., a module having the chips arranged in 4 rows and 1 column and a module having the chips arranged in 2 rows and 2 columns may be regarded as different types.

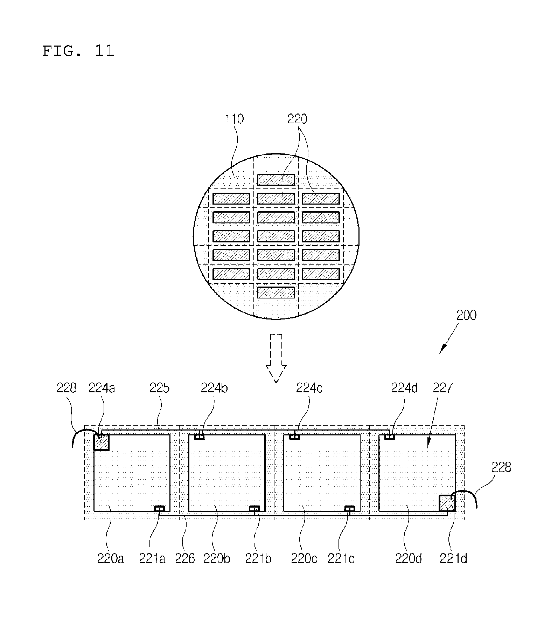

Fig. 11 is a schematic plan view illustrating a light emitting diode module 200 according to the sixth embodiment of the present invention. Different from the chip level packaging shown in Fig. 1, Fig. 11 illustrates the light emitting diode module 200 formed by respectively connecting P-type electrode pads 221a, 221b, 221c, and 221d and N-type electrode pads 224a, 224b, 224c, and 224d of two or more (four in Fig. 11) light emitting diode chips 220a, 220b, 220c, and 220d among the light emitting diode chips 220 at a wafer level by metal lines 225 and 226.

Thus, the light emitting diode module 200, in which four light emitting diode chips 220a, 220b, 220c, and 220d are electrically connected to one another in parallel, is formed at a wafer level. Next, as described above, a coating layer 227 is formed, in which phosphor/silicon for converting to a desired light is mixed.

The wafer 110 having the coating layer 227 formed thereon is oven cured to cure the coating layer 227, and the light emitting diode module 200 is diced.

The diced light emitting diode module 200 is wired to electrodes of a lead frame (not shown) through a subsequent packaging process. In a typical packaging process, electrode pads of all light emitting diode chips attached to the lead frame (not shown) and the electrodes must be wired. On the other hand, with respect to the light emitting diode module 200, since the plurality of light emitting diode chips 220a, 220b, 220c, and 220d are already electrically connected to one another by the metal lines 225 and 226, one of the plurality of electrode pads in the module 200 and the electrode may be connected to each other. That is, as illustrated in Fig. 11, the P-type electrode pad 224a and the N-type electrode pad 221d of the light emitting diode module 200 may be wired to the electrodes of the lead frame (not shown). Thus, a wiring process during packaging is much simplified and thus, productivity may improve.

When the light emitting diode module 200 of the present sixth embodiment is compared with the light emitting diode module 100 of the fifth embodiment, only the number of the light emitting diode chips constituting the module is different and the rest is the same. Therefore, descriptions in the fifth embodiment may also be applied to the present sixth embodiment. For example, all descriptions related to the wavelength detection, determination of a fluorescent substance mixing ratio for wavelength compensation, and phosphor coating layer formed on the light emitting diode chip according to the determined mixing ratio may be applied to the sixth embodiment. Accordingly, an overlapping description will be omitted.

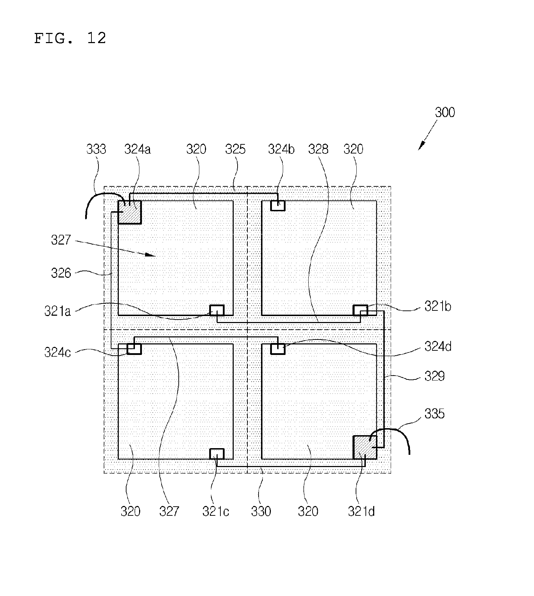

A light emitting diode module 300 according to the seventh embodiment of the present invention, as shown in Fig. 12, includes four light emitting diode chips 320 formed on a wafer 110 and a plurality of metal lines 325, 326, 327, 328, 329, and 330 electrically connecting the light emitting diode chips 320 to one another.

The metal lines 325, 326, and 327 electrically connect P-type electrode pads 324a, 324b, 324c, and 324d on the four light emitting diode chips 320 to one another.

The metal lines 328, 329, and 330 electrically connect N-type electrode pads 321a, 321b, 321c, and 321d on the four light emitting diode chips 320 to one another.

The light emitting diode module 300 further includes a phosphor coating layer 327 formed on the each light emitting diode chip 320.

The light emitting diode module 300 may be packaged by connecting one 321d of the N-type electrode pads 321a, 321b, 321c, and 321d and one 324a of the P-type electrode pads 324a, 324b, 324c, and 324d to electrodes of a lead frame (not shown) by wires 333 and 335.

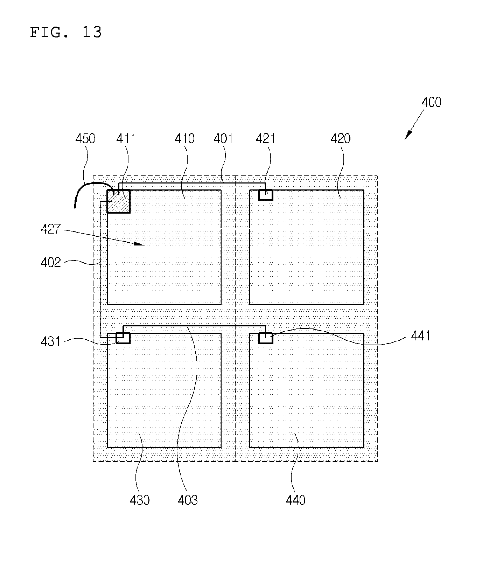

A light emitting diode module 400 according to the eighth embodiment of the present invention, as shown in Fig. 13, includes four light emitting diode chips 410, 420, 430, and 440 formed on a wafer 110 and a plurality of metal lines 401, 402, and 403 electrically connecting the four light emitting diode chips 410, 420, 430, and 440 to one another. The light emitting diode module 400 is the same as the light emitting module 300 of the seventh embodiment in terms of having the four light emitting diode chips 410, 420, 430, and 440 arranged in a matrix structure of 2 rows and 2 columns.

The plurality of metal lines 401, 402 and 403 electrically connect P-type electrode pads 411, 421, 431, and 441 of the four light emitting diode chips 410, 420, 430, and 440 to one another. Accordingly, the four light emitting diode chips 410, 420, 430, and 440 are connected to one another in parallel.

Meanwhile, N-type electrode pads of the four light emitting diode chips 410, 420, 430, and 440 are formed on a surface opposite to a surface coated with a fluorescent layer 427, i.e., a rear surface of the wafer 110 in Fig. 13. Herein, the N-type electrode pad may be prepared as a common electrode. Of course, in some cases, the P-type electrode pad may be prepared as a common electrode instead of the N-type electrode pad. Herein, the fluorescent layer 427 is for emitting a desired light by compensating a wavelength distribution, and since the forming method thereof was described in detail in the fifth embodiment, it will be omitted in the present embodiment.

During packaging, one of the P-type electrode pads 411, 421, 431, and 441 and an electrode (+) of a lead frame (not shown) are connected to each other by a wire 450, and the N-type electrode pad of the rear surface of the wafer 110 and an electrode (-) of the lead frame (not shown) are connected to each other by a wire.

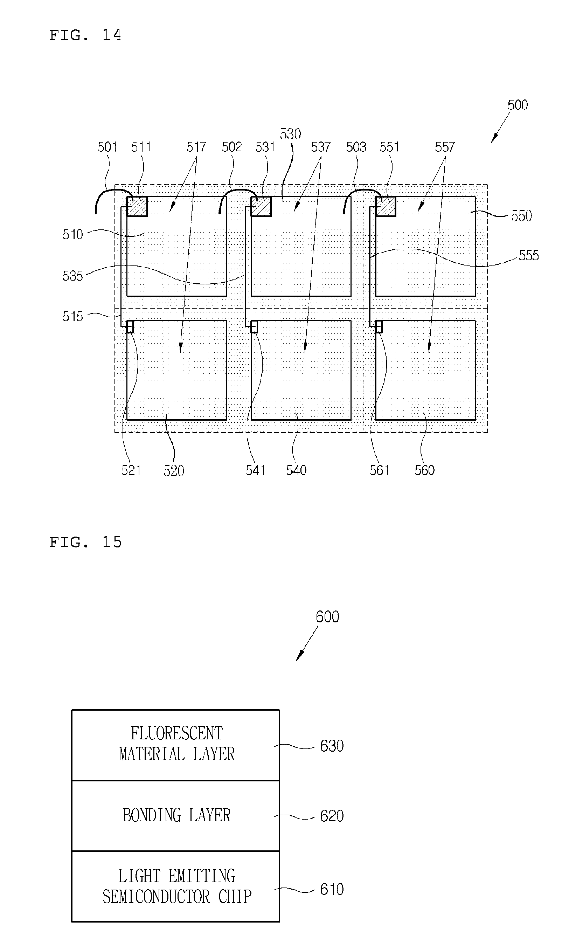

A light emitting diode module 500 according to the ninth embodiment of the present invention, as shown in Fig. 14, is composed of six light emitting diode chips 510, 520, 530, 540, 550, and 560. For reference, Fig. 14 illustrates the diced light emitting diode module 500 for the simplicity of the description.

For example, among a plurality of light emitting diode chips constituting the light emitting diode module 500, the two light emitting diode chips 510 and 520 on the left are for emitting red light as a desired light (target light), the two light emitting diode chips 530 and 540 in the middle are for emitting green light as a target light, and the two light emitting diode chips 550 and 560 on the right may be for emitting blue light as a target light.

An N-type semiconductor layer (not shown), an active layer (not shown), and a P-type semiconductor layer (not shown) are formed on the wafer 110 and N-type electrode pads (not shown) and P-type electrode pads 511, 521, 531, 541, 551, and 561 connected to the respective semiconductor layers are formed. Accordingly, the plurality of light emitting diode chips having a wavelength distribution is formed on the wafer 110. For example, when a light emitting diode chip emitting blue light is formed on the wafer 110, the light emitting diode chip may have a wavelength distribution range of about 420 nm to 470 nm.

With respect to the plurality of light emitting diode chips 510 and 520 for emitting red light as a target light, a top surface of the chips 510 and 520 is coated with a fluorescent substance having a phosphor mixing ratio for converting blue light of the plurality of light emitting diode chips 510 and 520 to red light. As a result, a red light conversion coating layer 517 is formed on the chips 510 and 520. Herein, when blue light wavelengths of the plurality of light emitting diode chips 510 and 520 are different to each other, the plurality of light emitting diode chips 510 and 520 may be respectively coated with fluorescent substances having different mixing ratios in order to compensate for obtaining red light having the same wavelength.

With respect to the plurality of light emitting diode chips 530 and 540 for emitting green light as a target light, a top surface of the chips 530 and 540 is coated with a fluorescent substance having a phosphor mixing ratio for converting blue light of the plurality of light emitting diode chips 510 and 520 to green light. As a result, a green light conversion coating layer 537 is formed on the chips 530 and 540. Herein, when blue light wavelengths of the plurality of light emitting diode chips 530 and 540 are different to each other, the plurality of light emitting diode chips 530 and 540 may be respectively coated with fluorescent substances having different mixing ratios in order to compensate for obtaining green light having the same wavelength.

With respect to the plurality of light emitting diode chips 550 and 560 for emitting blue light as a target light, the plurality of light emitting diode chips 550 and 560 may be respectively coated with fluorescent substances having different mixing ratios in order to obtain the plurality of light emitting diode chips 550 and 560 having the same blue light wavelength. In some cases, wavelength of any one light emitting diode chip 560 may be compensated based on the other light emitting diode chip 550. When an output error of the blue light wavelength of the plurality of light emitting diode chips 550 and 560 is in a predetermined range (e.g., a human's perceptible range of 4 nm), the chips 550 and 560 may be only coated with a silicon material without having the fluorescent substance mixed therein. As a result, a coating layer 557 for chip protection may be formed on the chips 550 and 560.

The light emitting diode module 500 may include metal lines 515, 535, and 555 for electrically connecting the plurality of light emitting diode chips 510, 520, 530, 540, 550, and 560 for each color.

The metal line 515 connects the P-type electrode pads 511 and 521 of the plurality of light emitting diode chips 510 and 520 for emitting red light as a target light. Herein, the P-type electrode pad 511 of the light emitting diode chip 510 may be connected to a (+) electrode of a not shown lead frame through a wire 501 in order to apply a bias voltage for emitting red light.

The metal line 535 connects the P-type electrode pads 531 and 541 of the plurality of light emitting diode chips 530 and 540 for emitting green light as a target light. Herein, the P-type electrode pad 531 of the light emitting diode chip 530 may be connected to a (+) electrode of a not shown lead frame through a wire 502 in order to apply a bias voltage for emitting green light.

The metal line 555 connects the P-type electrode pads 551 and 561 of the plurality of light emitting diode chips 550 and 560 for emitting blue light as a target light. Herein, the P-type electrode pad 551 of the light emitting diode chip 550 may be connected to a (+) electrode of a not shown lead frame through a wire 503 in order to apply a bias voltage for emitting blue light.

An N-type electrode pad (not shown) may be formed on a rear surface of the wafer 110 as a common electrode.

The N-type electrode pad (not shown) may also be connected to a (-) electrode of the lead frame through a wire (not shown).

When a bias voltage is applied to any one of the plurality of wires 501, 502, and 503, the light emitting module 500 according to the ninth embodiment having the foregoing configuration emits light having a corresponding color.

Also, when bias voltages are applied to two of the plurality of wires 501, 502, and 503, light corresponding to a mixed color is emitted.

When bias voltages are applied to the plurality of wires 501, 502, and 503 at the same time, white light may be emitted.

Thus, output light having various colors may be obtained by the single light emitting diode module 500. In this case, metal lines are designed so as to allow RGB colors to be individually controlled in the single module and wires are individually connected for each color. Each light emitting diode chip is coated with a phosphor/silicon mixing layer to obtain red, green, or blue light, and then the light emitting diode chips are separated into a module unit by using a dicing or laser cutting method. Light from the separated module is controlled through electrical connection and the separated module may be used for generating various colors by being designed such that color generation and combination of RGB lights may be possible. In particular, generation of various colors using RGB in a minimum pixel unit may be possible in high-quality lighting for interiors requiring various colors and indoor and outdoor display boards.

Meanwhile, as shown in Fig. 15, a light emitting diode 600 according to the tenth embodiment of the present invention includes a light emitting diode chip 610 composed of an N-type semiconductor layer (not shown), an active layer (not shown), and a P-type semiconductor layer (not shown); a fluorescent material layer 630 having a phosphor mixing ratio based on a wavelength of light emitted from the light emitting semiconductor chip 610 so as to convert the light emitted from the light emitting semiconductor chip 610 to a desired light and coated on the light emitting diode chip 610; and a bonding layer 620 disposed between the fluorescent material layer 630 and the light emitting semiconductor chip 610 to bond the fluorescent material layer 630 to the light emitting semiconductor chip.

Herein, the fluorescent material layer 630 may be a phosphor/silicon mixed layer in which a phosphor corresponding to the foregoing phosphor mixing ratio and silicon are mixed. That is, the fluorescent material layer 630 denotes a layer formed of the foregoing fluorescent substance. Herein, silicon may be replaced with other equivalent materials or an equivalent material may be mixed.

Herein, processes of forming the bonding layer 620 and the fluorescent material layer 630 may be performed at a wafer level as well as a packaging level.

In Fig. 15, the bonding layer 620 performs an adhesive function, in which the light emitting semiconductor chip 610 and the fluorescent material layer 630 are in contact with each other, and acts to increase bond strength. As described above, adhesion properties with respect to the light emitting semiconductor chip 610 substrate deteriorate as the phosphor mixing ratio in the fluorescent material layer 630 increases. As a result, the fluorescent layer 630 may be delaminated during subsequent processes (wire bonding, flip chip bonding, etc.) and the bonding layer 620 is for preventing the delamination.

A silicon resin, an epoxy resin, an organic polymer, or a glass resin may be used as the bonding layer 620. Herein, when a fluorescent material layer 630 forming process is not performed at a chip level (packaging level) but performed at a wafer level, bonding (adhesion) properties between the fluorescent material layer 630 and the light emitting semiconductor chip 610 substrate become more important.

In Fig. 15, the fluorescent material layer 630 is formed on the bonding layer 620 and conformal coating is performed in order to prevent a binning phenomenon in which a color deviation is generated by a thickness deviation of the fluorescent material layer 630. Also, the mixing ratio of the phosphor/silicon is controlled in order to compensate a wavelength distribution of the chip generated in an EPI MOCVD process.

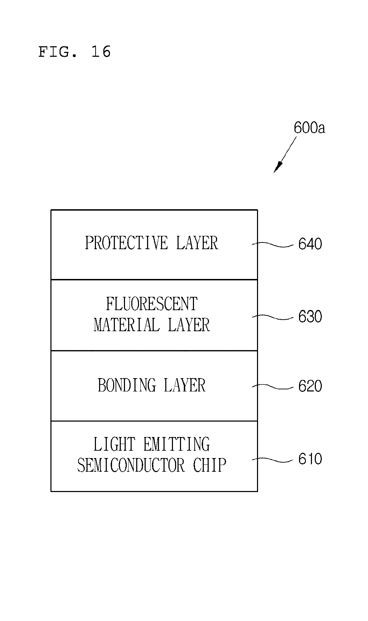

As shown in Fig. 16, a light emitting diode according to the eleventh embodiment of the present invention further includes a bonding layer 620 introduced before forming a fluorescent material layer 630 and a protective layer 640 for protecting a fluorescent material layer 630 on the fluorescent material layer 630. The fluorescent material protective layer 640, as shown in Fig. 15, is for preventing surface damage/scratch, which may be generated on the fluorescent material layer 630 during a subsequent package process after the fluorescent material layer 630 being introduced. A silicon resin, an epoxy resin, an organic polymer, or a glass resin may be used as the fluorescent material protective layer 640.

Herein, both of the bonding layer 620 and the protective layer 640 may be formed and any one of the foregoing layers may be formed.

Two embodiments of the foregoing methods of manufacturing light emitting diodes suggested in Figs. 15 and 16 according to the present invention will be described.

As shown in Fig. 15, a method of manufacturing a light emitting diode according to the twelfth embodiment of the present invention includes: depositing an N-type semiconductor layer, an active layer, and a P-type semiconductor layer on a wafer substrate 601 to form a light emitting semiconductor chip 610; detecting a wavelength of light emitted from the light emitting semiconductor chip 610; using wavelength data of the detected light emitting semiconductor chip to determine a phosphor mixing ratio corresponding thereto so as to allow the light emitting semiconductor chip to emit a desired light; forming a bonding layer on the light emitting semiconductor chip before coating the light emitting semiconductor chip with a fluorescent substance according to the determined phosphor mixing ratio; and forming a fluorescent material layer on the bonding layer according to the determined mixing ratio. The forming of the bonding layer and the forming of the fluorescent material layer in the method of manufacturing a light emitting diode according to the present twelfth embodiment may be simultaneously applied at a chip level or a wafer level.

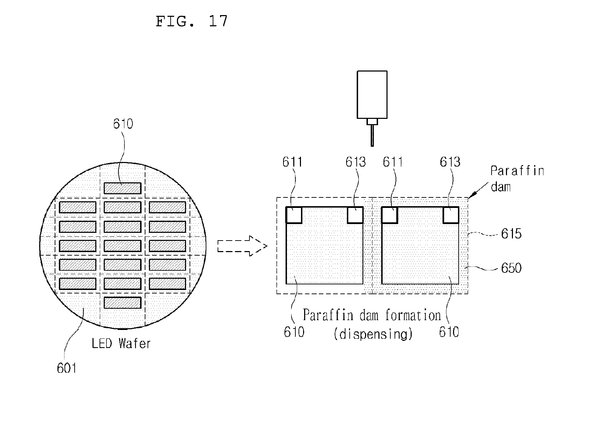

Herein, as shown in Fig. 17, a scribe line of the light emitting chip 610 is protected by printing a material such as paraffin and portions of metal pads 611 and 613 are printed along pad lines with a material such as paraffin, and thus, dispensed bonding layer 620, fluorescent material layer 630, and protective layer 640 materials may not penetrate into the pad portions. In this case, when the material such as paraffin is printed, a thickness thereof may be about 100 µm and a main function of the paraffin material is a role of a guide dam. A main process of the embodiment is described below.

The foregoing method of manufacturing a light emitting diode according to the twelfth embodiment of the present invention may further include printing a material, such as paraffin, on a scribe line 615 and portions of the electrode pads 611 and 613 of the each light emitting semiconductor chip 610 in the wafer substrate 601 to form a guide dam. Herein, the forming of the guide dam by printing the material such as paraffin may be commonly referred to as masking.

Herein, the forming of the guide dam may be performed before the forming of the bonding layer.

Meanwhile, the forming of the fluorescent material layer may include compensating a wavelength of each chip by respectively coating the fluorescent material layer 630 according to the phosphor mixing ratio determined in a wafer state for the each light emitting semiconductor chip 610.

Herein, the foregoing method of manufacturing a light emitting diode according to the twelfth embodiment of the present invention may further include forming a protective layer 640 formed on the fluorescent material layer 630 to protect the fluorescent material layer 630.

As shown in Fig. 16, a method of manufacturing a light emitting diode according to the thirteenth embodiment of the present invention includes: depositing an N-type semiconductor layer, an active layer, and a P-type semiconductor layer on a wafer substrate 601 to form a light emitting semiconductor chip 610; detecting a wavelength of light emitted from the light emitting semiconductor chip 610; using wavelength data of the detected light emitting semiconductor chip 610 to determine a phosphor mixing ratio corresponding thereto so as to allow the light emitting semiconductor chip 610 to emit a desired light; forming a fluorescent material layer according to the determined mixing ratio; and forming a protective layer on the fluorescent material layer. Herein, the method may be applied to any one of a chip level and a wafer level.

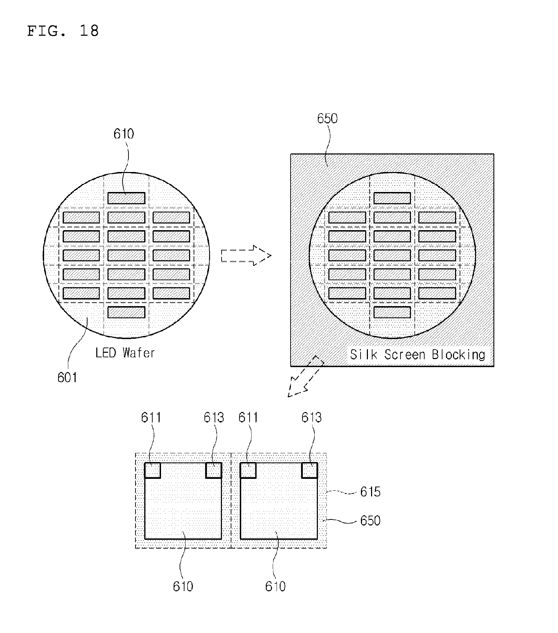

In this case, as shown in Fig. 18, a scribe line 615 between a semiconductor chip 610 and a chip 610 and portions of metal pads 611 and 613 may be masked by a silk screen 650 or metal mask 650. Since coating is performed after the masking, the bonding layer 620, fluorescent material layer 630, and protective layer 640 materials may not penetrate into the portions of the metal pads 611 and 613.

That is, the masking using the silk screen 650 or the metal mask 650 may be performed before the forming of the fluorescent material layer 630.

Also, the foregoing method of manufacturing a light emitting diode according to the thirteenth embodiment of the present invention may further include forming the bonding layer 620 performed between the masking and the forming of the fluorescent material layer 630.

Meanwhile, the forming of the fluorescent material layer 630 may include compensating a wavelength of each chip by respectively coating the fluorescent material layer 630 according to the phosphor mixing ratio determined in a wafer state for the each light emitting semiconductor chip 610.

The foregoing embodiments are merely presented to exemplify the present invention, and a person having ordinary skill in the art will understand from the above that various modifications and other equivalent embodiments are also possible.

Hence, the real protective scope of the present invention shall be determined by the technical scope of the accompanying claims.

## Claims

1. A light emitting diode comprising:
a light emitting semiconductor chip composed of an N-type semiconductor layer, an active layer, and a P-type semiconductor layer;
a fluorescent material layer having a phosphor mixing ratio based on a wavelength of light emitted from the light emitting semiconductor chip to convert the light emitted from the light emitting semiconductor chip to a desired light and coated on the light emitting diode chip; and
a bonding layer disposed between the fluorescent material layer and the light emitting semiconductor chip to bond the fluorescent material layer to the light emitting semiconductor chip.

2. The light emitting diode according to claim 1, wherein the bonding layer comprises at least any one of a silicon resin, an epoxy resin, an organic polymer, and a glass resin.

3. The light emitting diode according to claim 1, further comprising a protective layer coated on the fluorescent material layer to protect the fluorescent material layer.

4. The light emitting diode according to claim 3, wherein the protective layer comprises at least any one of a silicon resin, an epoxy resin, an organic polymer, and a glass resin.

5. The light emitting diode according to claim 1, wherein a wavelength of the light emitted from the light emitting semiconductor chip is a blue wavelength or ultraviolet wavelength.

6. A method of manufacturing a light emitting diode, the method comprising:
depositing an N-type semiconductor layer, an active layer, and a P-type semiconductor layer on a wafer substrate to form a light emitting semiconductor chip;
detecting a wavelength of light emitted from the light emitting semiconductor chip;
using wavelength data of the detected light emitting semiconductor chip to determine a phosphor mixing ratio corresponding thereto to allow the light emitting semiconductor chip to emit a desired light;
forming a bonding layer on the light emitting semiconductor chip before coating the light emitting semiconductor chip with a fluorescent substance according to the determined phosphor mixing ratio; and
forming a fluorescent material layer on the bonding layer according to the determined mixing ratio.

7. The method according to claim 6, further comprising masking a region of the light emitting semiconductor chip before the forming of the bonding layer.

8. The method according to claim 7, further comprising forming a protective layer on the fluorescent material layer.

9. A method of manufacturing a light emitting diode, the method comprising:
depositing an N-type semiconductor layer, an active layer, and a P-type semiconductor layer on a wafer substrate to form a light emitting semiconductor chip;
detecting a wavelength of light emitted from the light emitting semiconductor chip;
using wavelength data of the detected light emitting semiconductor chip to determine a phosphor mixing ratio corresponding thereto to allow the light emitting semiconductor chip to emit a desired light;
forming a fluorescent material layer according to the determined mixing ratio; and
forming a protective layer on the fluorescent material layer.

10. The method according to claim 9, further comprising masking a region of the light emitting semiconductor chip before the forming of the fluorescent material layer.
